# EUROPEAN PATENT APPLICATION

(11) **EP 4 576 218 A1**
(43) Date of publication of application: **25.06.2025**
(21) Application number: 23882287.8
(22) Date of filing: 19.09.2023
(51) Int. Cl.: H01L 27/146, H01L 31/00, H04N 5/70

(54) **SOLID-STATE IMAGING DEVICE AND METHOD FOR MANUFACTURING SOLID-STATE IMAGING DEVICE**

(30) Priority: 25.10.2022 JP 2022170682
(71) Applicant: Hamamatsu Photonics K.K., Hamamatsu-shi, Shizuoka 435-8558 (JP)
(72) Inventor: SUGIMOTO, Kenichi, Hamamatsu-shi, Shizuoka 435-8558 (JP)
(74) Representative: Hoffmann Eitle
(86) International application number: PCT/JP2023/033919
(87) International publication number: WO 2024/090074

(57) **Abstract**

A solid-state imaging device includes a support provided with a plurality of first terminals, a light receiving sensor including a frame portion provided with a plurality of second terminals and a light receiving portion formed to be thinner than the frame portion inside the frame portion, the light receiving sensor being disposed on the support such that the plurality of first terminals and the plurality of second terminals correspond to each other, a plurality of connection portions disposed between the support and the frame portion, and electrically connecting the plurality of first terminals and the plurality of second terminals, a support portion disposed between the support and the light receiving portion, and supporting the light receiving portion, and a resin layer disposed at least between the support and the light receiving portion.

## Description

### Technical Field

The present disclosure relates to a solid-state imaging device, and a method for manufacturing a solid-state imaging device.

### Background Art

There is known a solid-state imaging device including a support, a light receiving sensor disposed on the support, a resin layer disposed between the support and the light receiving sensor, and a plurality of connection portions electrically connecting a plurality of terminals provided on the support and a plurality of terminals provided on the light receiving sensor, in which the light receiving sensor includes a frame portion provided with the plurality of terminals and a light receiving portion formed to be thinner than the frame portion inside the frame portion (see, for example, Patent Literature 1).

### Citation List

### Patent Literature

Patent Literature 1: Japanese Unexamined Patent Publication No. H6-196680

### Summary of Invention

### Technical Problem

In the solid-state imaging device described above, it may be desired to reduce a thickness and/or increase an area of the light receiving portion. However, for example, when an attempt is made to reduce the thickness and/or increase the area of the light receiving portion, for example, by increasing the area of the light receiving portion while maintaining the thickness of the light receiving portion, the light receiving portion may be bent.

An object of the present disclosure is to provide a solid-state imaging device capable of suppressing bending of a light receiving portion formed to be thinner than a frame portion in a light receiving sensor, and a method for manufacturing a solid-state imaging device.

### Solution to Problem

A solid-state imaging device according to one aspect of the present disclosure is [1] "a solid-state imaging device including a support provided with a plurality of first terminals, a light receiving sensor including a frame portion provided with a plurality of second terminals and a light receiving portion formed to be thinner than the frame portion inside the frame portion, the light receiving sensor being disposed on the support such that the plurality of first terminals and the plurality of second terminals correspond to each other, a plurality of connection portions disposed between the support and the frame portion, and electrically connecting the plurality of first terminals and the plurality of second terminals, a support portion disposed between the support and the light receiving portion, and supporting the light receiving portion, and a resin layer disposed at least between the support and the light receiving portion".

In the solid-state imaging device according to the above [1], the plurality of second terminals provided in the frame portion of the light receiving sensor are electrically connected to the plurality of first terminals provided in the support by the plurality of connection portions. As a result, it is possible to ensure electrical connection between the support and the light receiving sensor. In addition, the support portion supports the light receiving portion between the support and the light receiving portion of the light receiving sensor, and the resin layer is disposed between the support and the light receiving portion. As a result, even in a case where the light receiving portion is thinned and/or increased in area, it is possible to suppress bending of the light receiving portion. Accordingly, according to the solid-state imaging device according to the above [1], it is possible to suppress the bending of the light receiving portion formed to be thinner than the frame portion in the light receiving sensor.

A solid-state imaging device according to one aspect of the present disclosure may be [2] "the solid-state imaging device according to the above [1], in which a thermal conductivity of the support portion is higher than a thermal conductivity of the resin layer". According to the solid-state imaging device according to the above [2], even in a case where the light receiving portion generates heat, the heat generated in the light receiving portion can be efficiently discharged to the support side.

A solid-state imaging device according to one aspect of the present disclosure may be [3] "the solid-state imaging device according to the above [2], in which the support portion is made of metal". According to the solid-state imaging device according to the above [3], it is possible to easily and reliably realize the support portion having a high thermal conductivity.

A solid-state imaging device according to one aspect of the present disclosure may be [4] "the solid-state imaging device according to any one of the above [1] to [3], in which each of the plurality of connection portions is made of metal having a melting point lower than a melting point of a material forming the support portion". According to the solid-state imaging device according to the above [4], for example, in a case where the plurality of first terminals and the plurality of second terminals are electrically connected by melting the plurality of connection portions, since it is possible to prevent the support portion from melting, it is possible to reliably support the light receiving portion by the support portion.

A solid-state imaging device according to one aspect of the present disclosure may be [5] "the solid-state imaging device according to any one of the above [1] to [4], in which the support portion is in surface contact with the light receiving portion". According to the solid-state imaging device according to the above [5], the supporting of the light receiving portion by the support portion can be stabilized. In addition, in a case where the thermal conductivity of the support portion is higher than the thermal conductivity of the resin layer, the heat generated in the light receiving portion can be more efficiently discharged to the support side.

A solid-state imaging device according to one aspect of the present disclosure may be [6] "the solid-state imaging device according to any one of the above [1] to [5], in which a height of the support portion from a surface of the support on the light receiving sensor side is substantially equal to a distance between the surface of the support and a surface of the frame portion on the support side". According to the solid-state imaging device according to the above [6], it is possible to more reliably suppress the bending of the light receiving portion.

A solid-state imaging device according to one aspect of the present disclosure may be [7] "the solid-state imaging device according to any one of the above [1] to [6], in which a plurality of support portions are disposed as the support portion between the support and the light receiving portion, and the plurality of support portions are separated from each other". According to the solid-state imaging device according to the above [6], it is possible to more reliably suppress the bending of the light receiving portion.

A solid-state imaging device according to one aspect of the present disclosure may be [8] "the solid-state imaging device according to the above [7], in which the resin layer is disposed in an entire region other than regions where the plurality of support portions are disposed among regions between the support and the light receiving portion". According to the solid-state imaging device according to the above [8], it is possible to reliably maintain a state where the bending of the light receiving portion is suppressed.

A solid-state imaging device according to one aspect of the present disclosure may be [9] "the solid-state imaging device according to the above [7] or [8], in which the plurality of support portions are two-dimensionally disposed at uniform pitches". According to the solid-state imaging device according to the above [9], it is possible to more reliably suppress the bending of the light receiving portion.

A solid-state imaging device according to one aspect of the present disclosure may be [10] "the solid-state imaging device according to any one of the above [7] to [9], in which a side surface of each of the plurality of support portions is curved so as to protrude outward". According to the solid-state imaging device according to the above [10], it is possible to suppress damage in the light receiving portion due to contact with each of the plurality of support portions.

A solid-state imaging device according to one aspect of the present disclosure may be [11] "the solid-state imaging device according to any one of the above [1] to [10], the resin layer is integrally disposed between the support and the light receiving portion and between the support and the frame portion". According to the solid-state imaging device according to the above [11], it is possible to reliably fix the light receiving sensor to the support.

A method for manufacturing a solid-state imaging device according to one aspect of the present disclosure is [12] "a method for manufacturing the solid-state imaging device according to any one of the above [1] to [11] including a first step of disposing the support portion on a surface of the support on the light receiving sensor side, a second step of disposing the plurality of connection portions on the plurality of first terminals or the plurality of second terminals, a third step of electrically connecting the plurality of first terminals and the plurality of second terminals via the plurality of connection portions after the first step and the second step, and a fourth step of disposing the resin layer between the support and the light receiving sensor while applying a pressure to the light receiving portion from a side opposite to the support after the third step".

In the method for manufacturing the solid-state imaging device according to the above [12], after the plurality of first terminals and the plurality of second terminals are electrically connected via the plurality of connection portions, the resin layer is disposed between the support and the light receiving sensor while applying a pressure to the light receiving portion from the side opposite to the support. As a result, a state where the bending of the light receiving portion is suppressed is maintained. Accordingly, according to the method for manufacturing the solid-state imaging device according to the above [12], it is possible to suppress the bending of the light receiving portion formed thinner than the frame portion in the light receiving sensor.

The method for manufacturing the solid-state imaging device according to one aspect of the present disclosure may be [13] "the method for manufacturing the solid-state imaging device according to the above [12], in which, in the fourth step, a pressure is applied to the light receiving portion from the side opposite to the support by increasing a pressure of a space positioned on the side opposite to the support with respect to the light receiving portion". According to the method for manufacturing the solid-state imaging device according to the above [13], it is possible to apply the pressure to the light receiving portion from the side opposite to the support while suppressing the damage in the light receiving portion.

The method for manufacturing the solid-state imaging device according to one aspect of the present disclosure may be [14] "the method for manufacturing the solid-state imaging device according to the above [13], in which, in the fourth step, the pressure of the space positioned on the side opposite to the support with respect to the light receiving portion is increased by blowing a gas to the light receiving portion from the side opposite to the support". According to the method for manufacturing the solid-state imaging device according to the above [14], the pressure of the space positioned on the opposite side of the support can be easily and reliably increased.

### Advantageous Effects of Invention

According to the present disclosure, it is possible to provide the solid-state imaging device capable of suppressing the bending of the light receiving portion formed thinner than the frame portion in the light receiving sensor, and the method for manufacturing the solid-state imaging device.

### Brief Description of Drawings

FIG. 1 is a plan view of a solid-state imaging device according to an embodiment.
FIG. 2 is a sectional view of the solid-state imaging device taken along line II-II illustrated in FIG. 1.
FIG. 3 is a sectional view illustrating a method for manufacturing the solid-state imaging device illustrated in FIG. 1.
FIG. 4 is a sectional view illustrating a method for manufacturing the solid-state imaging device illustrated in FIG. 1.
FIG. 5 is a sectional view illustrating a method for manufacturing the solid-state imaging device illustrated in FIG. 1.
FIG. 6 is a plan view of a solid-state imaging device according to a modification.
FIG. 7 is a plan view of a solid-state imaging device according to a modification.

### Description of Embodiments

Hereinafter, embodiments of the present disclosure will be described in detail with reference to the drawings. Note that, in the drawings, the same or corresponding parts are denoted by the same reference signs, and redundant description will be omitted.

### [Configuration of Solid-State Imaging Device]

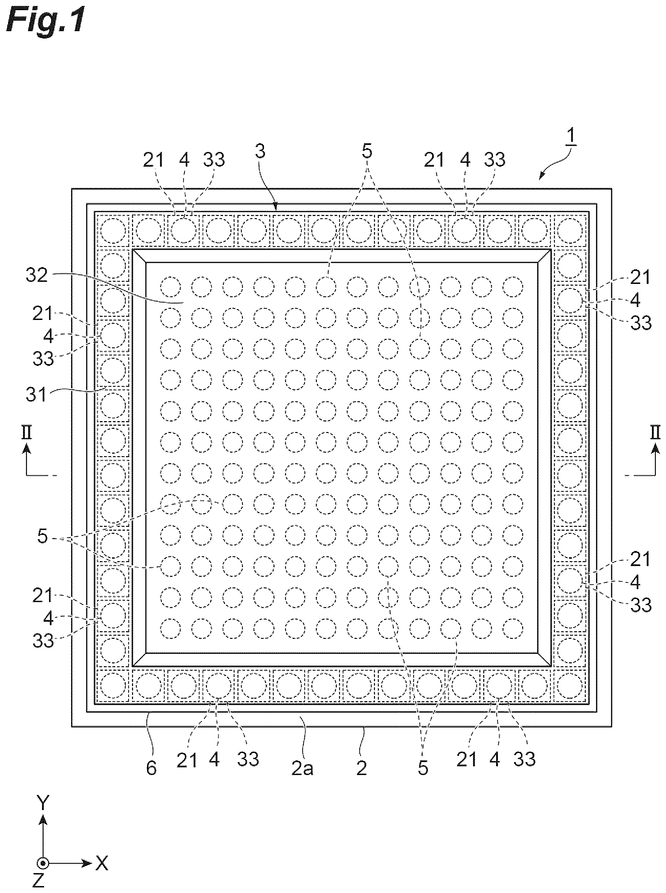

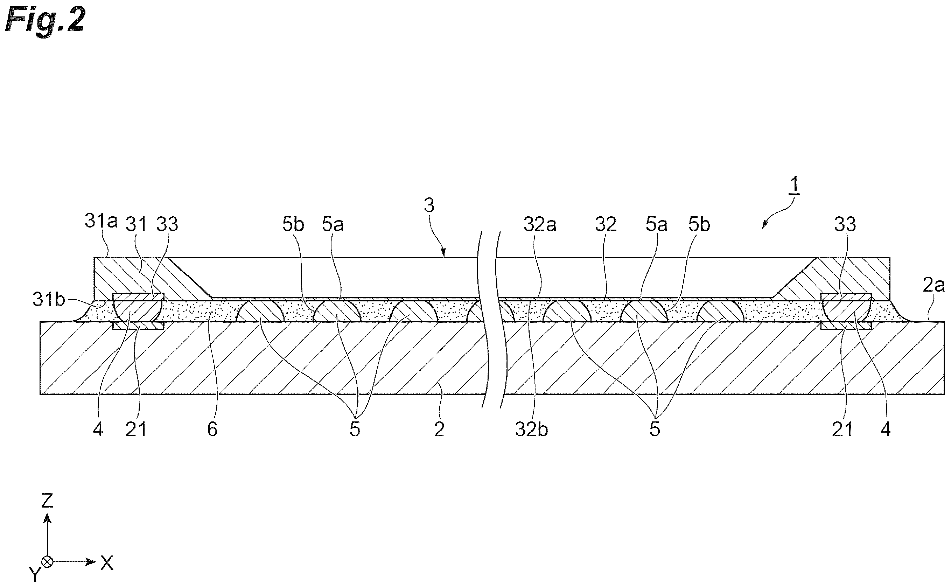

As illustrated in FIGS. 1 and 2, a solid-state imaging device 1 includes a support 2, a light receiving sensor 3, a plurality of connection portions 4, a plurality of support portions 5, and a resin layer 6. Hereinafter, a direction in which the support 2 and the light receiving sensor 3 are arranged is referred to as a Z-axis direction, one direction perpendicular to the Z-axis direction is referred to as an X-axis direction, and a direction perpendicular to both the Z-axis direction and the X-axis direction is referred to as a Y-axis direction.

A plurality of terminals (first terminals) 21 are provided in the support 2. The plurality of terminals 21 are disposed on a surface 2a of the support 2 on the light receiving sensor 3 side. In the present embodiment, the plurality of terminals 21 are arranged along an outer edge of the surface 2a. A shape of the support 2 is, for example, a rectangular plate shape with the Z-axis direction as a thickness direction. A main material of the support 2 is, for example, ceramic. A plurality of terminals (not illustrated) to which external wirings are electrically connected, and a plurality of wirings (not illustrated) that connect the plurality of terminals and the plurality of terminals 21 are further provided in the support 2.

The light receiving sensor 3 includes a frame portion 31 and a light receiving portion 32 which are integrally formed. Main materials of the frame portion 31 and the light receiving portion 32 are, for example, silicon. The frame portion 31 has a surface 31a opposite to the support 2 and a surface 31b on the support 2 side. The light receiving portion 32 has a surface 32a opposite to the support 2 and a surface 32b on the support 2 side. The light receiving portion 32 is formed to be thinner than the frame portion 31 inside the frame portion 31. In the present embodiment, the surface 32a of the light receiving portion 32 is a bottom surface of a recessed portion opened to the surface 31a of the frame portion 31, and the surface 32b of the light receiving portion 32 is positioned on the same plane as the surface 31b of the frame portion 31. The light receiving sensor 3 is a back-side incidence type light receiving sensor (for example, a CCD image sensor) in which the surface 32a of the light receiving portion 32 thinned with respect to the frame portion 31 is a light incident surface.

A plurality of terminals (second terminals) 33 are provided in the frame portion 31. The plurality of terminals 33 are disposed on the surface 31b of the frame portion 31. In the present embodiment, the plurality of terminals 33 are arranged along an outer edge of the surface 31b. A shape of the frame portion 31 is, for example, a rectangular frame shape with the Z-axis direction as a thickness direction. A thickness of the frame portion 31 is, for example, about 300 µm. A length of one side of the frame portion 31 is, for example, about several centimeters.

The light receiving portion 32 includes a plurality of pixels (not illustrated) that converts incident light into electric charges, and a transfer portion (not illustrated) that transfers electric charges accumulated in each of the plurality of pixels. The plurality of pixels are disposed in, for example, a matrix along the surface 32b of the light receiving portion 32. A shape of the light receiving portion 32 is, for example, a rectangular film shape with the Z-axis direction as a thickness direction. A thickness of the light receiving portion 32 is, for example, about 20 µm. A length of one side of the light receiving portion 32 is, for example, about several centimeters.

The light receiving sensor 3 is disposed on the surface 2a of the support 2 in a state of being separated from the surface 2a of the support 2. Each terminal 33 of the light receiving sensor 3 overlaps each terminal 21 of the support 2 as viewed from the Z-axis direction. That is, the light receiving sensor 3 is disposed on the support 2 such that the plurality of terminals 21 and the plurality of terminals 33 correspond to each other. A distance between the support 2 and the light receiving sensor 3 is, for example, about 50 µm.

The plurality of connection portions 4 are disposed between the support 2 and the frame portion 31 of the light receiving sensor 3. The plurality of connection portions 4 electrically connect the plurality of terminals 21 and the plurality of terminals 33. More specifically, each connection portion 4 electrically connects the corresponding pair of terminals 21 and 33. In the present embodiment, each connection portion 4 is made of metal (for example, SnBi or the like). A shape of each connection portion 4 as viewed from the Z-axis direction is, for example, a circular shape. A diameter of each connection portion 4 as viewed from the Z-axis direction is, for example, about 80 µm. Each connection portion 4 is, for example, a metal bump.

In the solid-state imaging device 1, an electric signal is input to and output from the light receiving portion 32 via the plurality of terminals 21 provided in the support 2, the plurality of connection portions 4, and the plurality of terminals 33 provided in the frame portion 31. Specifically, an electric signal for driving the transfer portion of the light receiving portion 32 is input to the transfer portion via the plurality of terminals 21 provided in the support 2, the plurality of connection portions 4, and the plurality of terminals 33 provided in the frame portion 31. In addition, an electric signal corresponding to the electric charge accumulated in each pixel of the light receiving portion 32 is output from each pixel via the plurality of terminals 21 provided in the support 2, the plurality of connection portions 4, and the plurality of terminals 33 provided in the frame portion 31.

The plurality of support portions 5 are disposed between the support 2 and the light receiving portion 32 of the light receiving sensor 3. The plurality of support portions 5 support the light receiving portion 32 in a state where the support portions 5 are separated from each other. The plurality of support portions 5 are two-dimensionally disposed at uniform pitches. In the present embodiment, each support portion 5 is made of metal (for example, SnAgCu or the like). A shape of each support portion 5 as viewed from the Z-axis direction is, for example, a circular shape. A diameter of each support portion 5 as viewed from the Z-axis direction is, for example, about 55 µm. Each support portion 5 is, for example, a metal bump. However, each support portion 5 is not electrically connected to the support 2, and is not electrically connected to the light receiving portion 32. Note that, each connection portion 4 is made of metal having a melting point lower than a melting point of the metal forming the support portion 5.

Each support portion 5 has a top surface 5a and a side surface 5b. The top surface 5a is an end surface of each support portion 5 on the light receiving portion 32 side, and is a flat surface perpendicular to the Z-axis direction. Each support portion 5 is in surface contact with the light receiving portion 32 on the top surface 5a. The side surface 5b is a surface extending from the surface 2a of the support 2 to the surface 32b of the light receiving portion 32 among the surfaces of the support portion 5. The side surface 5b is smoothly curved so as to protrude outward as viewed from a direction perpendicular to the Z-axis direction. An angle formed by a region of the side surface 5b of each support portion 5 on the light receiving portion 32 side and the surface 32b of the light receiving portion 32 decreases toward the light receiving portion 32. In the present embodiment, a height of each support portion 5 from the surface 2a of the support 2 is substantially the same as a distance between the surface 2a of the support 2 and the surface 31b of the frame portion 31. That is, a height of each support portion 5 from the surface 2a of the support 2 is 95% or more and 105% or less of the distance between the surface 2a of the support 2 and the surface 31b of the frame portion 31.

The resin layer 6 is integrally disposed between the support 2 and the light receiving portion 32 and between the support 2 and the frame portion 31. The resin layer 6 is disposed in the entire region other than regions where the plurality of connection portions 4 and the plurality of support portions 5 are disposed, among regions between the support 2 and the light receiving sensor 3. That is, in the regions between the support 2 and the light receiving portion 32, the resin layer 6 is disposed in the entire region other than the regions where the plurality of support portions 5 are disposed, among the regions. The resin layer 6 is disposed so as not to generate voids in the regions between the plurality of support portions 5. A material of the resin layer 6 is, for example, an epoxy resin. The resin layer 6 is, for example, an underfill resin layer. Note that, a thermal conductivity of each support portion 5 is higher than a thermal conductivity of the resin layer 6.

### [Method for Manufacturing Solid-State Imaging Device]

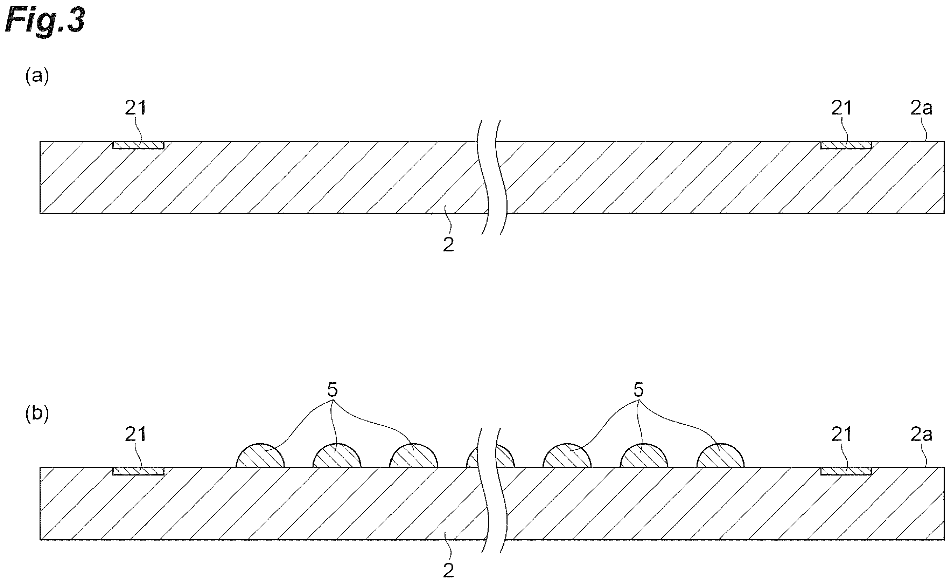

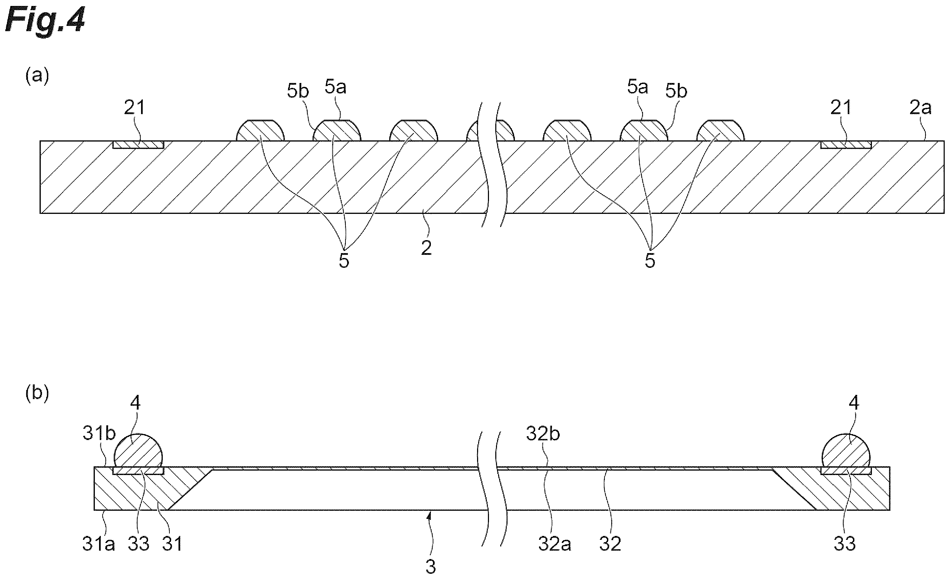

A method for manufacturing the solid-state imaging device 1 (a method for manufacturing the solid-state imaging device) will be described. First, as illustrated in (a) of FIG. 3, the support 2 is prepared. Subsequently, as illustrated in (b) of FIG. 3, the plurality of support portions 5 are disposed on the surface 2a of the support 2 (first step). More specifically, the plurality of support portions 5 are melted and re-solidified by heating, and thus, the plurality of support portions 5 are fixed on the surface 2a of the support 2. Subsequently, as illustrated in (a) of FIG. 4, the plurality of support portions 5 are simultaneously heated and pressed, and thus, the top surfaces 5a on the support portions 5 are formed. Here, the top surfaces 5a of the support portions 5 are positioned on the same plane. Note that, when the plurality of support portions 5 are pressed to form the top surfaces 5a on the support portion 5, the plurality of support portions 5 may not be heated.

On the other hand, as illustrated in (b) of FIG. 4, the light receiving sensor 3 is prepared, and the plurality of connection portions 4 are disposed on the plurality of terminals 33 (second step). More specifically, the plurality of connection portions 4 are melted and re-solidified by heating, and thus, the plurality of connection portions 4 are fixed on the plurality of terminals 33. Note that, the first step and the second step may be performed in parallel, the second step may be performed after the first step, or the first step may be performed after the second step.

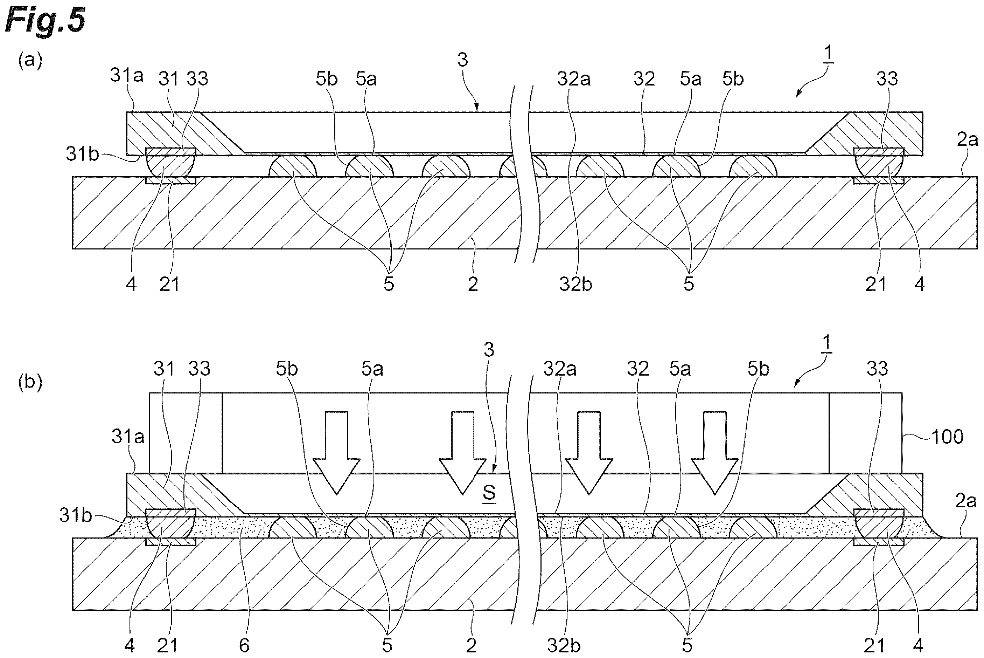

After the first step and the second step, as illustrated in (a) of FIG. 5, the plurality of terminals 21 and the plurality of terminals 33 are electrically connected via the plurality of connection portions 4 (third step). More specifically, the plurality of connection portions 4 are melted and re-solidified by heating, and thus, the plurality of terminals 21 and the plurality of terminals 33 are electrically connected via the plurality of connection portions 4. At this time, since each connection portion 4 is made of metal having a melting point lower than the melting point of the metal forming each support portion 5, each connection portion 4 can be melted while preventing each support portion 5 from being melted.

After the third step, as illustrated in (b) of FIG. 5, the resin layer 6 is disposed between the support 2 and the light receiving sensor 3 while a pressure is applied to the light receiving portion 32 from a side opposite to the support 2 (fourth step). More specifically, air (gas) is blown to the light receiving portion 32 from the side opposite to the support 2 by an air blowing device 100, and thus, a pressure of a space S positioned on the side opposite to the support 2 with respect to the light receiving portion 32 is increased. As a result, the pressure is applied to the light receiving portion 32 from the side opposite to the support 2. In this state, the resin layer 6 is cured, and the solid-state imaging device 1 is obtained. Note that, the plurality of support portions 5 may be brought into contact with the light receiving portion 32 in the third step, or may be brought into contact with the light receiving portion 32 in the fourth step (that is, in the third step, at least some of the plurality of support portions 5 are separated from the light receiving portion 32). In either case, the pressure is applied to the light receiving portion 32 from the side opposite to the support 2, and thus, the plurality of support portions 5 are reliably brought into contact with the light receiving portion 32.

### [Operations and Effects]

In the solid-state imaging device 1, the plurality of terminals 33 provided in the frame portion 31 of the light receiving sensor 3 are electrically connected to the plurality of terminals 21 provided on the support 2 by the plurality of connection portions 4. As a result, the support 2 and the light receiving sensor 3 can be reliably electrically connected to each other. In addition, the plurality of support portions 5 support the light receiving portion 32 between the support 2 and the light receiving portion 32 of the light receiving sensor 3, and the resin layer 6 is disposed between the support 2 and the light receiving portion 32. As a result, even in a case where a thickness and/or an area of the light receiving portion 32 is reduced and/or increased, it is possible to suppress the bending of the light receiving portion 32. Accordingly, according to the solid-state imaging device 1, it is possible to suppress the bending of the light receiving portion 32 formed thinner than the frame portion 31 in the light receiving sensor 3.

In the solid-state imaging device 1, the thermal conductivity of each support portion 5 is higher than the thermal conductivity of the resin layer 6. As a result, even in a case where the light receiving portion 32 generates heat, the heat generated in the light receiving portion 32 can be efficiently discharged to the support 2 side.

In the solid-state imaging device 1, each support portion 5 is made of metal. As a result, each support portion 5 having the high thermal conductivity can be easily and reliably realized.

In the solid-state imaging device 1, each connection portion 4 is made of metal having a melting point lower than the melting point of the metal forming each support portion 5. As a result, for example, in a case where the plurality of terminals 21 and the plurality of terminals 33 are electrically connected by melting the plurality of connection portions 4, since it is possible to prevent the plurality of support portions 5 from melting, it is possible to reliably support the light receiving portion 32 by the plurality of support portions 5.

In the solid-state imaging device 1, each support portion 5 is in surface contact with the light receiving portion 32. As a result, the supporting of the light receiving portion 32 by the plurality of support portions 5 can be stabilized. In addition, the heat generated in the light receiving portion 32 can be more efficiently discharged to the support 2 side.

In the solid-state imaging device 1, the height of each support portion 5 from the surface 2a of the support 2 is substantially the same as the distance between the surface 2a of the support 2 and the surface 31b of the frame portion 31. As a result, it is possible to more reliably suppress the bending of the light receiving portion 32.

In the solid-state imaging device 1, the support portions 5 are separated from each other. As a result, it is possible to more reliably suppress the bending of the light receiving portion 32.

In the solid-state imaging device 1, the resin layer 6 is disposed in the entire region other than the regions where the plurality of support portions 5 are disposed in the regions between the support 2 and the light receiving portion 32. As a result, a state where the bending of the light receiving portion 32 is suppressed can be reliably maintained.

In the solid-state imaging device 1, the plurality of support portions 5 are two-dimensionally disposed at uniform pitches. As a result, it is possible to more reliably suppress the bending of the light receiving portion 32.

In the solid-state imaging device 1, the side surface 5b of each support portion 5 is curved so as to protrude outward. As a result, it is possible to suppress damage in the light receiving portion 32 due to the contact of each support portion 5.

In the solid-state imaging device 1, the resin layer 6 is integrally disposed between the support 2 and the light receiving portion 32 and between the support 2 and the frame portion 31. As a result, the light receiving sensor 3 can surely be fixed to the support 2.

In the method for manufacturing the solid-state imaging device 1, after the plurality of terminals 21 and the plurality of terminals 33 are electrically connected via the plurality of connection portions 4, the resin layer 6 is disposed between the support 2 and the light receiving sensor 3 while applying the pressure to the light receiving portion 32 from the side opposite to the support 2. As a result, a state where the bending of the light receiving portion 32 is suppressed is maintained. Accordingly, according to the method for manufacturing the solid-state imaging device 1, it is possible to suppress the bending of the light receiving portion 32 formed to be thinner than the frame portion 31 in the light receiving sensor 3.

In the method for manufacturing the solid-state imaging device 1, the pressure is applied to the light receiving portion 32 from the side opposite to the support 2 by increasing the pressure of the space S positioned on the side opposite to the support 2 with respect to the light receiving portion 32. As a result, it is possible to apply the pressure to the light receiving portion 32 from the side opposite to the support 2 while suppressing the damage in the light receiving portion 32.

In the method for manufacturing the solid-state imaging device 1, the pressure of the space S positioned on the side opposite to the support 2 with respect to the light receiving portion 32 is increased by blowing air to the light receiving portion 32 from the side opposite to the support 2. As a result, the pressure of the space S positioned on the side opposite to the support 2 can be easily and reliably increased.

### [Modification]

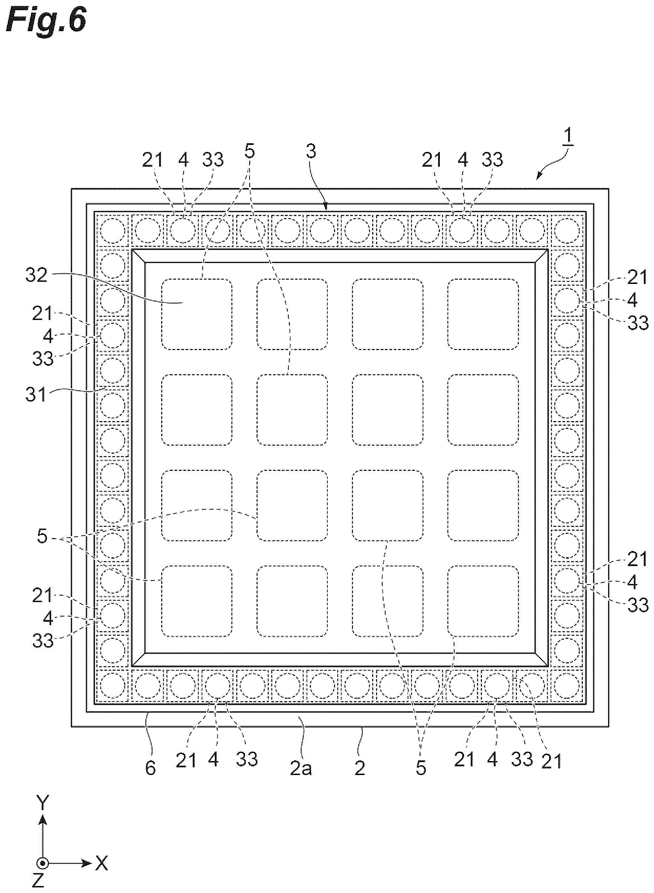

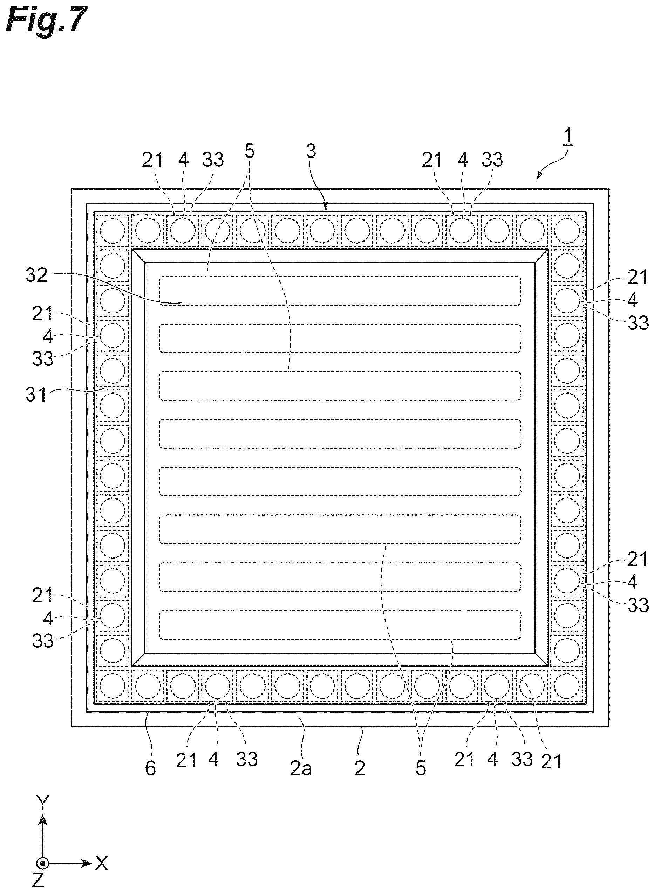

The present disclosure is not limited to the above embodiments. For example, the shape of each support portion 5 as viewed from the Z-axis direction is not limited to the circular shape. As illustrated in FIG. 6, the shape of each support portion 5 as viewed from the Z-axis direction may be a rectangular shape. In addition, as illustrated in FIG. 7, the shape of each support portion 5 as viewed from the Z-axis direction may be an elongated shape. In the example illustrated in FIG. 7, the support portions 5 extend in the X-axis direction, and the plurality of support portions 5 are disposed in the Y-axis direction. In addition, the plurality of support portions 5 may be two-dimensionally disposed at non-uniform pitches.

The solid-state imaging device 1 may include one support portion 5. As an example, when the support portion 5 extends in an X shape, an S shape, or a zigzag shape as viewed from the Z-axis direction, the resin layer 6 can be disposed in the entire region other than the region where the support portion 5 is disposed among the regions between the support 2 and the light receiving portion 32.

In the solid-state imaging device 1, at least one support portion 5 may be made of a material other than metal. In that case, at least one support portion 5 may be, for example, a resin bump. Even in a case where at least one support portion 5 is made of a material other than metal, when each connection portion 4 is made of metal having a melting point lower than the melting point of the material forming at least one support portion 5, for example, in a case where the plurality of terminals 21 and the plurality of terminals 33 are electrically connected by melting the plurality of connection portions 4, since at least one support portion 5 can be prevented from melting, the supporting of the light receiving portion 32 by at least one support portion 5 can be ensured. In addition, as long as at least one support portion 5 comes into contact with the light receiving portion 32, at least one support portion 5 may not be in surface contact with the light receiving portion 32. In that case, the method for manufacturing the solid-state imaging device 1 may not include a step of pressing the plurality of support portions 5 to form the top surfaces 5a on the support portions 5, and a hemispherical support portion 5 may be brought into contact with the light receiving portion 32. In addition, the side surface 5b of at least one support portion 5 may not be curved so as to protrude outward as viewed from a direction perpendicular to the Z-axis direction, such as a cylindrical surface. In addition, the thermal conductivity of at least one support portion 5 may be equal to or lower than the thermal conductivity of the resin layer 6. In addition, regardless of whether at least one support portion 5 is made of metal or made of a material other than metal, the melting point of the metal forming each connection portion 4 may be equal to or higher than the melting point of the material forming at least one support portion 5.

In the solid-state imaging device 1, the resin layer 6 may be separately disposed between the support 2 and the light receiving portion 32 and between the support 2 and the frame portion 31. Alternatively, as long as the resin layer 6 is disposed between the support 2 and the light receiving portion 32, the resin layer 6 may not be disposed between the support 2 and the frame portion 31. That is, the resin layer 6 may be disposed at least between the support 2 and the light receiving portion 32. In addition, in the regions between the support 2 and the light receiving portion 32, the resin layer 6 may not be disposed in the entire region other than the regions where the plurality of support portions 5 are disposed, among the regions. That is, in the regions between the support 2 and the light receiving portion 32, the resin layer 6 may be disposed in a part of the regions other than the regions where the plurality of support portions 5 are disposed among the regions. In addition, in a case where the resin layer 6 is disposed between the support 2 and the frame portion 31, the resin layer 6 may not be disposed in the entire region other than the regions where the plurality of connection portions 4 are disposed among the regions between the support 2 and the frame portion 31. That is, in a case where the resin layer 6 is disposed between the support 2 and the frame portion 31, the resin layer 6 may be disposed in a part of the regions other than the regions where the plurality of connection portions 4 are disposed among the regions between the support 2 and the frame portion 31.

In the method for manufacturing the solid-state imaging device 1, in the second step, the plurality of connection portions 4 may be disposed on the plurality of terminals 21 of the support 2 instead of the plurality of connection portions 4 being disposed on the plurality of terminals 33 of the light receiving sensor 3. In addition, in the fourth step, a gas other than air may be blown to the light receiving portion 32 from the side opposite to the support 2 to increase the pressure of the space S. In addition, in the fourth step, the pressure may be applied to the light receiving portion 32 from the side opposite to the support 2 by increasing the pressure of the space S by a method other than the gas blowing. In addition, the pressure may be applied to the light receiving portion 32 from the side opposite to the support 2 by pressing some member against the light receiving portion 32 from the side opposite to the support 2.

### Reference Signs List

- 1: solid-state imaging device
- 2: support
- 2a: surface
- 3: light receiving sensor
- 4: connection portion
- 5: support portion
- 5b: side surface
- 6: resin layer
- 21: terminal (first terminal)
- 31: frame portion
- 31b: surface
- 32: light receiving portion
- 32b: surface
- 33: terminal (second terminal)

## Claims

1. A solid-state imaging device comprising:
a support provided with a plurality of first terminals;
a light receiving sensor including a frame portion provided with a plurality of second terminals and a light receiving portion formed to be thinner than the frame portion inside the frame portion, the light receiving sensor being disposed on the support such that the plurality of first terminals and the plurality of second terminals correspond to each other;
a plurality of connection portions disposed between the support and the frame portion, and electrically connecting the plurality of first terminals and the plurality of second terminals;
a support portion disposed between the support and the light receiving portion, and supporting the light receiving portion; and
a resin layer disposed at least between the support and the light receiving portion.

2. The solid-state imaging device according to claim 1, wherein a thermal conductivity of the support portion is higher than a thermal conductivity of the resin layer.

3. The solid-state imaging device according to claim 2, wherein the support portion is made of metal.

4. The solid-state imaging device according to any one of claims 1 to 3, wherein each of the plurality of connection portions is made of metal having a melting point lower than a melting point of a material forming the support portion.

5. The solid-state imaging device according to any one of claims 1 to 4, wherein the support portion is in surface contact with the light receiving portion.

6. The solid-state imaging device according to any one of claims 1 to 5, wherein a height of the support portion from a surface of the support on the light receiving sensor side is substantially equal to a distance between the surface of the support and a surface of the frame portion on the support side.

7. The solid-state imaging device according to any one of claims 1 to 6, wherein
a plurality of support portions are disposed as the support portion between the support and the light receiving portion, and
the plurality of support portions are separated from each other.

8. The solid-state imaging device according to claim 7, wherein the resin layer is disposed in an entire region other than regions where the plurality of support portions are disposed among regions between the support and the light receiving portion.

9. The solid-state imaging device according to claim 7 or 8, wherein the plurality of support portions are two-dimensionally disposed at uniform pitches.

10. The solid-state imaging device according to any one of claims 7 to 9, wherein a side surface of each of the plurality of support portions is curved so as to protrude outward.

11. The solid-state imaging device according to any one of claims 1 to 10, wherein the resin layer is integrally disposed between the support and the light receiving portion and between the support and the frame portion.

12. A method for manufacturing the solid-state imaging device according to any one of claims 1 to 11, comprising:
a first step of disposing the support portion on a surface of the support on the light receiving sensor side;
a second step of disposing the plurality of connection portions on the plurality of first terminals or the plurality of second terminals;
a third step of electrically connecting the plurality of first terminals and the plurality of second terminals via the plurality of connection portions after the first step and the second step; and
a fourth step of disposing the resin layer between the support and the light receiving sensor while applying a pressure to the light receiving portion from a side opposite to the support after the third step.

13. The method for manufacturing the solid-state imaging device according to claim 12, wherein, in the fourth step, a pressure is applied to the light receiving portion from the side opposite to the support by increasing a pressure of a space positioned on the side opposite to the support with respect to the light receiving portion.

14. The method for manufacturing the solid-state imaging device according to claim 13, wherein, in the fourth step, the pressure of the space positioned on the side opposite to the support with respect to the light receiving portion is increased by blowing a gas to the light receiving portion from the side opposite to the support.
